# FASCICULE DE BREVET EUROPEEN

(11) **EP 0 659 040 B1**
(45) Date de publication et mention de la délivrance du brevet: **26.06.1996**
(21) Numéro de dépôt: 94402764.8
(22) Date de dépôt: 02.12.1994
(51) Int. Cl.: H05K 7/14, H05K 5/02

(54) **Module additif pour variateur de vitesse**
Zusatzmodul für Drehzahlwandler
Additional module for variable speed drive

(30) Priorité: 17.12.1993 FR 9315335
(43) Date de publication de la demande: 21.06.1995
(73) Titulaire: SCHNEIDER ELECTRIC SA, F-92100 Boulogne-Billancourt (FR)
(72) Inventeur: Dore, Christophe, F-75005 Paris (FR)
(74) Mandataire: Saint Martin, René

(56) Documents cités:
- EP-A- 0 256 937
- EP-A- 0 505 938
- IBM TECHNICAL DISCLOSURE BULLETIN., vol.27, no.12, Mai 1985, NEW YORK US pages 6887 - 6890 'EXTENSION DEVICE FOR A PERSONAL COMPUTER'

## Description

La présente invention se rapporte à un module additif destiné à être monté sur un variateur de vitesse et constitué d'un boîtier qui contient un ensemble électronique et est pourvu à l'arrière d'un connecteur s'embrochant sur un connecteur correspondant prévu sur le variateur de vitesse.

Les variateurs de vitesse de type convertisseurs de fréquence qui sont destinés à contrôler la vitesse des moteurs asynchrones triphasés comprennent essentiellement d'une part un redresseur qui fournit une tension continue à un filtre capacitif de lissage (convertisseur alternatif-continu) et d'autre part un onduleur à transistors de puissance (convertisseur continu-alternatif) alimenté par ladite tension continue filtrée.

Le variateur de vitesse répond aux fonctionnalités les plus courantes. Il est possible de configurer le variateur de vitesse pour des applications plus complexes grâce à des additifs (en option) tels que:
- additif de dialogue opérateur destiné à assurer la visualisation des paramètres et des défauts ainsi que la configuration des fonctions;
- additif de liaison avec un ordinateur de type P.C. ou compatible permettant notamment le téléchargement et l'enregistrement des réglages;
- additif de liaison série sur bus automate.

Ces modules se présentent sous la forme d'un boîtier contenant une électronique et pourvu à l'arrière d'un connecteur pouvant être embroché sur un connecteur ménagé à l'avant du variateur de vitesse.

L'invention a pour but de fournir un module additif pour variateur de vitesse présentant un agencement en L qui minimise l'encombrement. Cet agencement en L facilite l'addition d'une carte à mémoire au module.

Conformément à l'invention, le boîtier r a une forme générale en L dont l'aile frontale s'encastre par sa paroi latérale dans un logement prévu dans la face avant dudit variateur de vitesse, le connecteur étant porté par la paroi arrière, et dont l'aile latérale vient se loger sur un côté du variateur de vitesse et que l'ensemble électronique logé à l'intérieur du boîtier comprend deux cartes électroniques à circuits imprimés l'une frontale, l'autre latérale reliées électriquement l'une à l'autre, dans l'angle du L, et faisant entre elles un angle correspondant sensiblement à l'angle formé entre les ailes du boîtier.

Selon une caractéristique, la carte latérale porte un connecteur de carte à mémoire disposé de manière à permettre l'enfichage de la carte à mémoire sur le côté du variateur.

Selon une autre caractéristique, les deux cartes sont reliées électriquement par des broches pliées.

L'invention va maintenant être décrite avec plus de détail en se référant à un mode de réalisation donné à titre d'exemple et représenté par les dessins annexés sur lesquels:

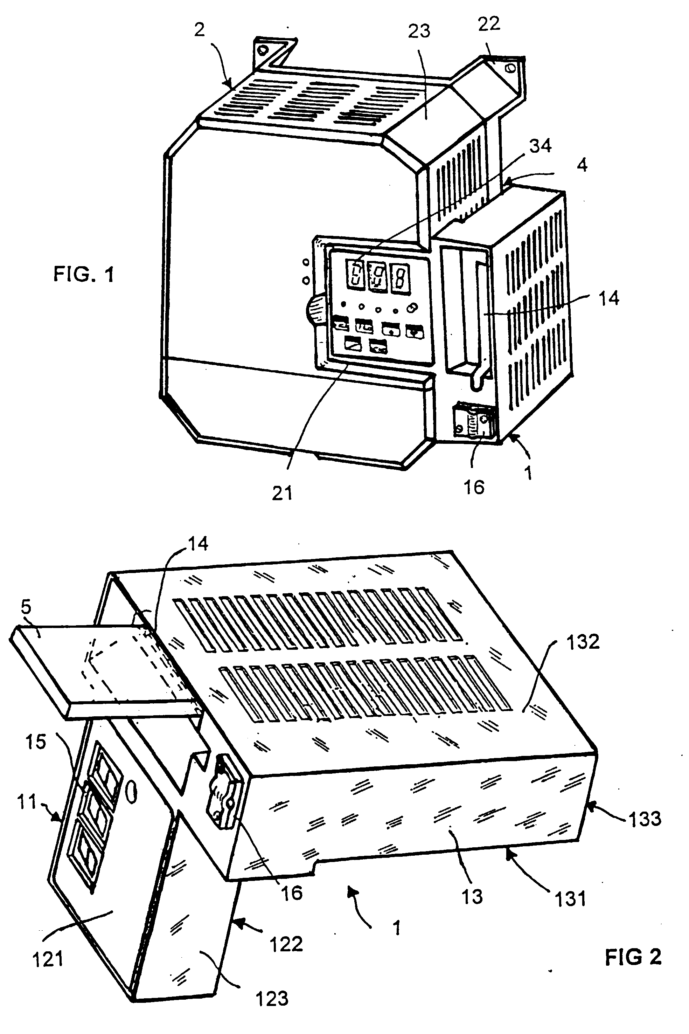

- la figure 1 est une vue en perspective du module additif monté sur le variateur associé;
- la figure 2 est un vue en perpective du module additif;

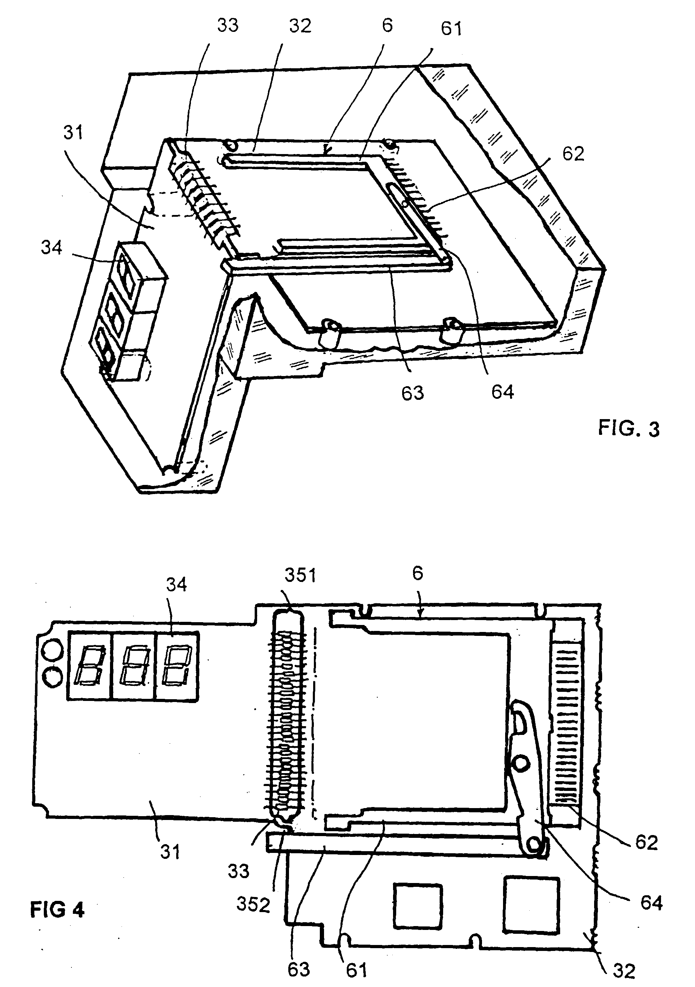

- la figure 3 est un vue en perpective montrant l'intérieur du module additif;
- la figure 4 est un vue de la carte interne du module additif représentée avant montage;

Le module additif objet de l'invention est associé à un variateur de vitesse repéré 2 sur les dessins.

Ce variateur de vitesse peut par exemple être un convertisseur statique de fréquence qui comprend de manière connue en soi un onduleur relié par l'intermédiaire d'un filtre capacitif de lissage à un redresseur à diodes relié aux conducteurs de phase du réseau. L'onduleur comporte trois bras de pont reliés chacun à un enroulement de phase d'un moteur asynchrone. Chaque bras de l'onduleur est équipé, de manière connue en soi, de deux composants de puissance de type interrupteurs associés à des diodes de récupération. Le point milieu de chaque couple d'interrupteurs d'un même bras est relié à un enroulement de phase du moteur. Les interrupteurs statiques sont constitués par des transistors de puissance ou par d'autres composants blocables analogues. Un circuit de commande à microprocesseur commande les composants de puissance de manière à rendre passants et bloquants ces composants suivant une stratégie définie.

Le coffret 23 du variateur présente, à l'arrière, des pattes de fixation 22.

Sur la face avant, le coffret 23 du variateur présente un logement 21 dans lequel peut s'encastrer et s'embrocher un module additif 1. Le fond de ce logement présente un connecteur mâle (ou femelle) à plusieurs broches dans lequel s'enfiche le connecteur femelle (ou mâle) conjugué du module additif 1. Ce module additif est verrouillé dans le logement lors de l'exploitation ou être retiré avant exploitation.

Le module additif 1 présente un boîtier 11 ayant une forme générale en L. L'aile frontale du boîtier a une forme parallélépipédique délimitée par la paroi arrière 122 qui porte le connecteur, par la paroi latérale 123 qui s'encastre dans le logement du variateur et par la paroi avant 121 qui reste apparente sur la face avant du variateur lorsque le module est encastré. L'aile latérale du boîtier se termine au niveau de la paroi avant 121 et présente une face latérale 131 qui fait face au coffret du variateur lorsque l'ensemble est monté et une face latérale extérieure 132 orientée vers l'extérieur. Le fond 133 du boîtier est disposé à l'arrière du côté de la fixation du variateur. La face latérale extérieure 132 présente des ouïes servant à la ventilation de l'électronique. La forme du module est adaptée de manière à former, entre la face latérale 131 et le côté du boîtier de variateur, un dégagement 4 servant à la ventilation.

Le boîtier du module additif s'encastre au niveau de l'aile frontale dans le logement 21 du coffret de variateur de vitesse.

Le circuit électronique logé à l'intérieur du boîtier comporte deux cartes à circuits imprimés l'une frontale 31, l'autre latérale 32, ces deux cartes étant reliées électriquement l'une à l'autre, dans l'angle du L, par des broches pliées 33. Les deux cartes font entre elles un angle correspondant sensiblement à l'angle formé entre les ailes du boîtier.

La carte frontale 31 porte des afficheurs 34 à 7 segments et autres composants.

Avant montage, les deux cartes 31 et 32 sont reliées l'une à l'autre par deux ponts de liaison 351 et 352 qui sont cassés par pliage au moment du montage de la carte dans le boîtier 11. Les deux cartes 31 et 32 sont électriquement réunies par les broches 33 qui se plient au moment du montage.

Le module est adapté à recevoir une carte à mémoire repérée 5 au standard PC-MCIA ("Personal Computer Memory Card International Association") ou tout autre standard équivalent. La carte latérale 32 porte un connecteur de carte 6 adapté à recevoir cette carte à mémoire 5. Cet agencement permet l'enfichage de la carte à mémoire 5 sur le côté du coffret du variateur, parallèlement au plan de la carte latérale et perpendiculairement au plan de fixation du variateur. La carte à mémoire 5 peut être introduite dans le connecteur parallèlement à un côté du coffret de variateur par une ouverture 14 disposée sur la paroi avant 121 du boîtier 11. Le connecteur 6 comporte un guidage 61 pour la carte 5 et à l'arrière les broches 62 d'alimentation et de données sur lesquelles viennent s'enficher les cosses de connexion de la carte 5. Le débrochage de la carte à mémoire 5 s'effectue par un poussoir 63 et un levier basculant 64 agissant sur l'arrière de la carte à mémoire 5.

L'aile latérale du boîtier 11 du module additif présente sur la face orientée vers le variateur, une clavette à tenons qui s'engage dans une rainure d'accrochage disposée sur le côté du coffret de variateur. Cette rainure d'accrochage peut être ménagée dans une pièce rapportée et fixée sur le côté du coffret de variateur.

La face avant 121 du module additif porte, au-dessous de l'ouverture 14, un serre-câbles 16.

Il est bien entendu que l'on peut, sans sortir du cadre de l'invention, imaginer des variantes et des perfectionnements de détail et de même envisager l'emploi de moyens équivalents.

## Revendications

1. Module additif(destiné à être) monté sur un variateur de vitesse et constitué d'un boîtier (11) contenant un ensemble électronique et pourvu à l'arrière d'un connecteur s'embrochant sur un connecteur correspondant prévu sur le variateur de vitesse (2), caractérisé par le fait que le boîtier (11) a une forme générale en L dont l'aile frontale s'encastre par sa paroi latérale (123) dans un logement (21) prévu dans la face avant dudit variateur de vitesse, le connecteur étant porté par la paroi arrière (122), et dont l'aile latérale vient se loger sur un côté du variateur de vitesse et que l'ensemble électronique logé à l'intérieur du boîtier comprend deux cartes électroniques (31- 32) à circuits imprimés l'une frontale, l'autre latérale reliées électriquement l'une à l'autre, dans l'angle du L, et faisant entre elles un angle correspondant sensiblement à l'angle formé entre les ailes du boîtier (11).

2. Module selon la revendication 1, caractérisé par le fait que la carte latérale (32) porte un connecteur (6) de carte à mémoire (5) disposé de manière à permettre l'enfichage de la carte à mémoire (5) sur le côté du coffret du variateur.

3. Module selon l'une quelconque des revendications précédentes, caractérisé par le fait que les deux cartes (31, 32) sont reliées par des broches pliées (33).

4. Module selon l'une quelconque des revendications précédentes, caractérisé par le fait que l'aile latérale du boîtier (11) présente des moyens de fixation coopérant avec des moyens de fixation ménagés sur le côté du coffret du variateur.

5. Module selon l'une quelconque des revendications précédentes, caractérisé par le fait que la paroi avant (121) de l'aile frontale porte, au-dessous d'une d'une ouverture (14) servant à l'introduction d'une carte à mémoire (5), un serre-câbles (16).

## Patentansprüche

1. Für die Montage auf einen Drehzahlwandler vorgesehenes Zusatzmodul, bestehend aus einem Gehäuse (11) das eine elektronische Einheit beinhaltet und dessen Hinterteil mit einem Stecker versehen ist, der auf einen entsprechen, auf dem Drehzahlwandler (2) vorgesehenen Stecker eingesteckt wird, dadurch gekennzeichnet, dass das Gehäuse (11) die Hauptform eines « L » erweist, dessen Stimflügel durch seine Seitenwand in eine in der Vorderseite des betroffenen Drehzahlwandlers vorgesehene Aufnahme eingeführt wird, dabei wird der Stecker von der Hinterwand getragen, und dessen Seitenflügel in eine Seite des Drehzahlwandlers eingeführt wird, und dass die innerhalb des Gehäuses befindliche elektronische Einheit aus zwei elektronischen miteinander in dem « L » Winkel elektrisch verbundenen Leiterplattenkarten besteht, eine stirnseitige und eine seitliche, die zueinander einen wesentlich dem Winkel zwischen den Gehäuseflügeln entsprechenden Winkel bilden.

2. Modul gemäss Anspruch 1, dadurch gekennzeichnet, dass die seitliche Karte (32) einen Stecker (6) für eine Chipkarte (5) trägt, derweise angeordnet, dass die Chipkarte (5) auf der Seite des Drehzahlwandlerkasten eingesteckt werden kann.

3. Modul nach einem der vorstehenden Ansprüche, dadurch gekennzeichnet, dass beide Karten (31, 32) mittels gebeugten Stiften (33) miteinander verbunden sind.

4. Modul nach einem der vorstehenden Ansprüche, dadurch gekennzeichnet, dass der Seitenflügel des Gehäuses (11) mit Verbindungsmittel versehen ist, die mit den auf der Seite des Drehzahlwandlerkasten vorgesehenen Befestigungsmitteln zusammenwirken.

5. Modul nach einem der vorstehenden Ansprüche, dadurch gekennzeichnet, dass die Vorderwand (2) des Stirnflügels unterhalb einer Öffnung (14) für die Einführung einer Chipkarte (5) eine Einführungstülle (16) trägt.

## Claims

1. Add-on module adapted to be mounted on a variable speed drive and including a casing containing an electronic circuit and provided at the rear with a connector adapted to plug into a corresponding connector provided on said variable speed drive, wherein said casing is generally L-shape with a front portion carrying said connector adapted to be positioned in front of the front of said variable speed drive and a second portion accommodated on one side of said variable speed drive, said electronic circuit including front and side printed circuit boards electrically connected to each other and the angle between which is substantially equal to the angle between said front and second portions of said casing.

2. Module according to claim 1 wherein said side circuit board carries a connector for a memory card disposed to enable insertion of said memory card on the side of said case of said variable speed drive.

3. Module according to claim 1 wherein said two circuit boards are connected by bent pins.

4. Module according to claim 1 wherein said side portion of said casing has fixing means cooperating with fixing means on the side of said case of said variable speed drive.

5. Module according to claim 1 wherein the front of said module carries a cable clamp below an opening for inserting a memory card.
